# EUROPEAN PATENT APPLICATION

(11) **EP 4 350 988 A1**
(43) Date of publication of application: **10.04.2024**
(21) Application number: 22836888.2
(22) Date of filing: 05.07.2022
(51) Int. Cl.: H03F 1/52

(54) **TRANSIMPEDANCE AMPLIFIER AND TRANSIMPEDANCE AMPLIFIER CONTROL METHOD**

(30) Priority: 09.07.2021 CN 202110779890
(71) Applicant: Huawei Technologies Co., Ltd., Shenzhen, Guangdong 518129 (CN)
(72) Inventor: JING, Lei, Shenzhen, Guangdong 518129 (CN); TAN, Chen, Xianning West Road Xi'an, Shaanxi 710049 (CN); LI, Dan, Xianning West Road Xi'an, Shaanxi 710049 (CN)
(74) Representative: MERH-IP Matias Erny Reichl Hoffmann Patentanwälte PartG mbB
(86) International application number: PCT/CN2022/103802
(87) International publication number: WO 2023/280137

(57) **Abstract**

Embodiments of this application disclose a trans-impedance amplifier and a trans-impedance amplifier control method that are used in the field of circuit technologies. A trans-impedance amplifier TIA includes an inverting amplification circuit and a voltage clamping circuit. The inverting amplification circuit is connected in parallel to the voltage clamping circuit. The inverting amplification circuit includes a first PMOS transistor and a first NMOS transistor that have a common gate. A source of the first PMOS transistor is connected to a drain of the first NMOS transistor. The voltage clamping circuit includes a second PMOS transistor and a second NMOS transistor that have a common gate. Gates of the two transistors are connected to an input end of the TIA. A source of the second NMOS transistor and a drain of the second PMOS transistor are connected to an output end of the TIA. The voltage clamping circuit may provide a compensation current to avoid an excessively high or low output voltage of the trans-impedance amplifier. In this way, a voltage difference between the source and the drain of the first PMOS transistor and a voltage difference between the source and the drain of the first NMOS transistor can be controlled, to avoid an over-voltage phenomenon, thereby extending service life of the first PMOS transistor and the first NMOS transistor.

## Description

This application claims priority to Chinese Patent Application No. 202110779890.0, filed with the China National Intellectual Property Administration on July 9, 2021 and entitled "TRANS-IMPEDANCE AMPLIFIER AND TRANS-IMPEDANCE AMPLIFIER CONTROL METHOD", which is incorporated herein by reference in its entirety.

### TECHNICAL FIELD

Embodiments of this application relate to the field of circuit technologies, and in particular, to a trans-impedance amplifier and a control method thereof.

### BACKGROUND

A trans-impedance amplifier (trans-impedance amplifier, TIA) is a front-end amplifier of a photoelectric detector (for example, a photodiode), and is configured to convert a current signal output by the photoelectric detector into a voltage signal. The working principle of the TIA is as follows: A feedback resistor is added at two ends of an operational amplifier, and the feedback resistors convert a current into a voltage according to the Ohm's law and outputs the voltage.

An existing TIA uses a CMOS structure, which is formed by a PMOS transistor and an NMOS transistor connected in series. An input end of the TIA is separately connected to a gate of the PMOS transistor and a gate of the NMOS transistor, and an input end voltage is used to control turn-on/off of the PMOS transistor and the NMOS transistor, to control an output voltage of the trans-impedance amplifier.

Because the current signal received by the TIA is a burst signal, before the TIA reaches a stable state, a large current may instantaneously flow into the input end of the TIA, causing an excessively high voltage of the input end, and causing an excessively low voltage of an output end. In this way, a voltage between a source and a drain of the NMOS transistor is likely to be greater than a breakdown voltage of the NMOS transistor. This may damage the NMOS transistor. Therefore, how to solve an over-voltage problem of the TIA is key to improve performance and service life of the TIA.

### SUMMARY

Embodiments of this application provide a trans-impedance amplifier and a trans-impedance amplifier control method.

A first aspect of embodiments of this application provides a trans-impedance amplifier TIA. The TIA includes an inverting amplification circuit and a voltage clamping circuit. The inverting amplification circuit is connected in parallel to the voltage clamping circuit. The inverting amplification circuit includes a first PMOS transistor and a first NMOS transistor that have a common gate. Gates of the first PMOS transistor and the first NMOS transistor are connected to form an input end of the TIA. A source of the first PMOS transistor is connected to a drain of the first NMOS transistor to form an output end of the inverting amplification circuit. The voltage clamping circuit includes a second PMOS transistor and a second NMOS transistor that have a common gate. Gates of the second PMOS transistor and the second NMOS transistor are connected to the input end of the TIA. A source of the second NMOS transistor and a drain of the second PMOS transistor are connected to an output end of the TIA. In addition, a drain of the second NMOS transistor is connected to a direct current power supply, and a source of the second PMOS transistor is grounded.

A voltage clamping module performs compensation on a load current based on an input voltage to control a voltage of an output point. When the input voltage (a gate voltage) is excessively low, the first NMOS transistor and the second NMOS transistor are cut off, and the first PMOS transistor and the second PMOS transistor are turned on. In this case, a compensation current is provided by the second PMOS transistor to the first PMOS transistor. In this way, an output voltage value can be reduced, to ensure that an output voltage is not excessively high. A voltage difference between the drain and a source of the first NMOS transistor is not excessively high, so that an over-voltage phenomenon of the first NMOS transistor is avoided. The foregoing structure can ensure that the first NMOS transistor is in a safe working state.

When the input voltage is excessively high, the first PMOS transistor and the second PMOS transistor are cut off, and the first NMOS transistor and the second NMOS transistor are turned on. In this case, the compensation current is provided by the second NMOS transistor to the first NMOS transistor. In this way, the output voltage value can be increased, to ensure that the output voltage is not excessively low. A voltage difference between a drain and the source of the first PMOS transistor is not excessively high, so that an over-voltage phenomenon of the first PMOS transistor is avoided, and it is ensured that the first PMOS transistor is in the safe working state.

In the foregoing TIA, the voltage clamping module may perform compensation for a load circuit based on a voltage at the input end. The output voltage is protected and controlled within a normal range. In this way, an over-voltage phenomenon of a CMOS transistor caused by an excessively large drain-source voltage difference of the CMOS transistor can be avoided, and it is ensured that the CMOS transistor is in the safe working state. This prevents deviation of a working point from a breakdown point due to a sudden change of a current signal, which may damage the CMOS transistor. The performance of the trans-impedance amplifier can be greatly improved. In addition, the voltage clamping module has advantages such as a fast response speed, and can process an instantaneous change in node voltages caused by a burst signal. Therefore, stability of the trans-impedance amplifier is improved.

In an optional implementation, turn-on voltages of the first PMOS transistor and the first NMOS transistor are both less than turn-on voltages of the second PMOS transistor and the second NMOS transistor. In this way, if an input voltage value is within a normal swing range, neither a gate voltage of the second NMOS transistor nor a gate voltage of the second PMOS transistor reaches the turn-on voltage. Because both the second NMOS transistor and the second PMOS transistor are in a cutoff state, the voltage clamping circuit does not work. In this way, it can be ensured that reverse amplification performance of the TIA is not affected.

In an optional implementation, the TIA further includes a feedback resistor circuit. The feedback resistor circuit is connected in parallel to the inverting amplification circuit. The feedback resistor circuit is configured to convert an input current signal of the TIA into a voltage signal. A feedback resistor may convert the current signal into the voltage signal. In addition, introduction of the feedback resistor can make the inverting amplification circuit form a closed system. In this way, stability of the inverting amplification circuit is improved, and a gain of the inverting amplification circuit is improved.

In an optional implementation, the feedback resistor circuit includes a first feedback branch, a second feedback branch, and a third feedback branch that are connected in parallel. The first feedback branch includes a first resistor, a second resistor, and a first switch. The first resistor is connected in series to the second resistor, and the first switch is connected in parallel to two ends of the second resistor. The second feedback branch includes a third resistor and a second switch, and the third resistor is connected in series to the second switch. The third feedback branch includes a fourth resistor and a third switch, and the fourth resistor is connected in series to the third switch. The feedback resistor circuit includes three feedback branches that are connected in parallel, and each feedback branch has a switch. An on/off state of the switch on the first feedback branch may affect a conversion rate of the inverting amplification circuit. However, on/off states of the switches on the second feedback branch and the third feedback branch affect whether the third resistor and the fourth resistor are connected in parallel. In this way, a resistance of the feedback resistor circuit is affected, and finally a gain of the trans-impedance amplifier is affected. The foregoing feedback resistor circuit can be used to implement switching between two conversion rates and three gain modes of the trans-impedance amplifier, thereby improving flexibility of the trans-impedance amplifier.

In an optional implementation, the third feedback branch further includes a feedback capacitor. The feedback capacitor is connected in parallel to two ends of the fourth resistor, and is configured to compensate for a phase margin. When the TIA is in a low gain mode, a phase difference of a signal increases. In this case, the feedback capacitor needs to be added to compensate for the phase margin and restore the signal. In this way, working performance of the TIA is improved.

In an optional implementation, two ends of the feedback resistor circuit may be further connected in parallel to a second voltage clamping circuit. The second voltage clamping circuit includes a third PMOS transistor and a third NMOS transistor that have a common gate. Gates of the third PMOS transistor and the third NMOS transistor are connected to an input end of the feedback resistor circuit. A source of the third NMOS transistor and a drain of the third PMOS transistor are connected to an output end of the feedback resistor circuit. A drain of the third NMOS transistor is connected to a direct current power supply, and a source of the third PMOS transistor is grounded. Because the voltage clamping circuit is also added to the feedback resistor circuit, after a voltage of the output end is fed back to the input end, a voltage of the input end may be clamped. In this way, the input voltage can be controlled to avoid being excessively high or low. In this way, the over-voltage phenomenon of the CMOS transistor is avoided, and the source-drain voltage difference of the CMOS transistor is kept in a normal working state. The service life and working performance of the CMOS transistor are further improved.

In an optional implementation, the TIA further includes a load circuit. An input end of the load circuit is connected to the output end of the inverting amplification circuit. An output end of the load circuit is the output end of the trans-impedance amplifier TIA. The load circuit is configured to adjust a gain of the reverse amplification module to improve performance of the TIA.

In an optional implementation, the load circuit includes a load PMOS transistor and a load NMOS transistor. Agate of the load PMOS transistor is connected to a gate of the load NMOS transistor to form the input end of the load circuit. A source of the load PMOS transistor is connected to a drain of the load NMOS transistor. The gate of the load PMOS transistor and the gate of the load NMOS transistor are connected to the source of the load PMOS transistor and the drain of the load NMOS transistor. The load circuit uses a load CMOS transistor. The load CMOS transistor is equivalent to a resistor with a variable resistance, and a parameter of the TIA is adjusted by changing the resistance, thereby improving flexibility of the trans-impedance amplifier.

In an optional implementation, the load circuit further includes a load capacitor. A first end of the load capacitor is connected to the output end of the load circuit. A second end of the load capacitor is grounded. The load capacitor is configured to adjust an open-loop bandwidth of the inverting amplification circuit.

A second aspect of embodiments of this application provides another trans-impedance amplifier TIA. The TIA includes a first inverting amplifier, a second inverting amplifier, a third inverting amplifier, a first voltage clamping circuit, a second voltage clamping circuit, and a third voltage clamping circuit. The first inverting amplifier, the second inverting amplifier, and the third inverting amplifier are sequentially connected in series. The first voltage clamping circuit is connected in parallel to two ends of the first inverting amplifier. The second voltage clamping circuit is connected in parallel to two ends of the second inverting amplifier. The third voltage clamping circuit is connected in parallel to two ends of the third inverting amplifier.

The first inverting amplifier includes a first PMOS transistor and a first NMOS transistor that have a common gate. Gates of the first PMOS transistor and the first NMOS transistor are connected to form an input end of the TIA. A source of the first PMOS transistor is connected to a drain of the first NMOS transistor to form an output end of the first inverting amplifier. The second inverting amplifier includes a second PMOS transistor and a second NMOS transistor that have a common gate. Gates of the second PMOS transistor and the second NMOS transistor are connected to form an input end of the second inverting amplifier. The input end of the second inverting amplifier is connected to the output end of the first inverting amplifier. A source of the second PMOS transistor is connected to a drain of the second NMOS transistor to form an output end of the second inverting amplifier. The third inverting amplifier includes a third PMOS transistor and a third NMOS transistor that have a common gate. Gates of the third PMOS transistor and the third NMOS transistor are connected to form an input end of the third inverting amplifier. The input end of the third inverting amplifier is connected to the output end of the second inverting amplifier. A source of the third PMOS transistor is connected to a drain of the third NMOS transistor to form an output end of the TIA.

The first voltage clamping circuit includes a fourth PMOS transistor and a fourth NMOS transistor that have a common gate. Gates of the fourth PMOS transistor and the fourth NMOS transistor are connected to the input end of the TIA. A source of the fourth NMOS transistor and a drain of the fourth PMOS transistor are connected to the output end of the first inverting amplifier. A drain of the fourth NMOS transistor is connected to a direct current power supply, and a source of the fourth PMOS transistor is grounded. The second voltage clamping circuit includes a fifth PMOS transistor and a fifth NMOS transistor that have a common gate. Gates of the fifth PMOS transistor and the fifth NMOS transistor are connected to the input end of the second inverting amplifier. A source of the fifth NMOS transistor and a drain of the fifth PMOS transistor are connected to the output end of the second inverting amplifier. A drain of the fifth NMOS transistor is connected to the direct current power supply, and a source of the fifth PMOS transistor is grounded. The third voltage clamping circuit includes a sixth PMOS transistor and a sixth NMOS transistor that have a common gate. Gates of the sixth PMOS transistor and the sixth NMOS transistor are connected to the input end of the third inverting amplifier. A source of the sixth NMOS transistor and a drain of the sixth PMOS transistor are connected to the output end of the TIA. A drain of the sixth NMOS transistor is connected to the direct current power supply, and a source of the sixth PMOS transistor is grounded.

In an optional implementation, turn-on voltages of the fourth PMOS transistor and the fourth NMOS transistor are both less than turn-on voltages of the first PMOS transistor and the first NMOS transistor. Turn-on voltages of the fifth PMOS transistor and the fifth NMOS transistor are both less than turn-on voltages of the second PMOS transistor and the second NMOS transistor. Turn-on voltages of the sixth PMOS transistor and the sixth NMOS transistor are both less than turn-on voltages of the third PMOS transistor and the third NMOS transistor.

In an optional implementation, the TIA further includes a feedback resistor circuit. A first end of the feedback resistor circuit is connected to the output end of the TIA. A second end of the feedback resistor circuit is connected to the input end of the TIA. The feedback resistor circuit is configured to convert an input current signal of the TIA into a voltage signal.

In an optional implementation, the feedback resistor circuit includes a first feedback branch, a second feedback branch, and a third feedback branch that are connected in parallel. The first feedback branch includes a first resistor, a second resistor, and a first switch. The first resistor is connected in series to the second resistor. The first switch is connected in parallel to two ends of the second resistor. The second feedback branch includes a third resistor and a second switch. The third resistor is connected in series to the second switch. The third feedback branch includes a fourth resistor and a third switch. The fourth resistor is connected in series to the third switch.

In an optional implementation, the third feedback branch further includes a feedback capacitor. The feedback capacitor is connected in parallel to two ends of the fourth resistor. The feedback capacitor is configured to compensate for a phase margin.

In an optional implementation, two ends of the feedback resistor circuit may be further connected in parallel to a fourth voltage clamping circuit. The fourth voltage clamping circuit includes a third PMOS transistor and a third NMOS transistor that have a common gate. Gates of the third PMOS transistor and the third NMOS transistor are connected to an input end of the feedback resistor circuit. A source of the third NMOS transistor and a drain of the third PMOS transistor are connected to an output end of the feedback resistor circuit. A drain of the third NMOS transistor is connected to the direct current power supply, and a source of the third PMOS transistor is grounded.

In an optional implementation, the TIA further includes a first load circuit, a second load circuit, and a third load circuit. The first load circuit includes a first load PMOS transistor, a first load NMOS transistor, a fourth switch, and a fifth switch. A gate of the first load PMOS transistor is connected to a gate of the first load NMOS transistor. A source of the first load PMOS transistor is connected to a drain of the first load NMOS transistor. The gate of the first load PMOS transistor and the gate of the first load NMOS transistor are connected to the source of the first load PMOS transistor and the drain of the first load NMOS transistor.

The gate of the first load PMOS transistor and the gate of the first load NMOS transistor are connected to the output end of the first inverting amplifier. The source of the first load PMOS transistor and the drain of the first load NMOS transistor are connected to the input end of the second inverting amplifier. One end of the fourth switch is connected to the direct current power supply, and the other end is connected to a drain of the first load PMOS transistor. One end of the fifth switch is connected to a source of the first load NMOS transistor, and the other end is grounded.

The second load circuit includes a second load PMOS transistor, a second load NMOS transistor, a third load PMOS transistor, a third load NMOS transistor, a sixth switch, and a seventh switch. Agate of the second load PMOS transistor is connected to a gate of the second load NMOS transistor. A source of the second load PMOS transistor is connected to a drain of the second load NMOS transistor. The gate of the second load PMOS transistor and the gate of the second load NMOS transistor are connected to the source of the second load PMOS transistor and the drain of the second load NMOS transistor.

A gate of the third load PMOS transistor is connected to a gate of the third load NMOS transistor. A source of the third load PMOS transistor is connected to a drain of the third load NMOS transistor. The gate of the third load PMOS transistor and the gate of the third load NMOS transistor are connected to the source of the third load PMOS transistor and the drain of the third load NMOS transistor.

The gate of the second load PMOS transistor and the gate of the second load NMOS transistor are connected to the output end of the second inverting amplifier. The source of the second load PMOS transistor and the drain of the second load NMOS transistor are connected to the gate of the third load PMOS transistor and the gate of the third load NMOS transistor. One end of the sixth switch is connected to the direct current power supply, and the other end is connected to a drain of the second load PMOS transistor. One end of the seventh switch is connected to a source of the second load NMOS transistor, and the other end is grounded. The source of the third load PMOS transistor and the drain of the third load NMOS transistor are connected to the input end of the third inverting amplifier.

The third load circuit includes a fourth load PMOS transistor and a fourth load NMOS transistor. A gate of the fourth load PMOS transistor is connected to a gate of the fourth load NMOS transistor. A source of the fourth load PMOS transistor is connected to a drain of the fourth load NMOS transistor. The gate of the fourth load PMOS transistor and the gate of the fourth load NMOS transistor are connected to an output end of the third inverting amplifier. The source of the fourth load PMOS transistor and the drain of the fourth load NMOS transistor are the output end of the TIA.

In an optional implementation, the first load circuit further includes a first load capacitor and an eighth switch. The second load circuit further includes a second feedback capacitor and a ninth switch. One end of the eighth switch is connected to the source of the first load PMOS transistor and the drain of the first load NMOS transistor. The other end is connected to one end of the first load capacitor. The other end of the first load capacitor is grounded. One end of the ninth switch is connected to the source of the third load PMOS transistor and the drain of the third load NMOS transistor. The other end is connected to one end of the second load capacitor, and the other end of the second load capacitor is grounded.

A third aspect of embodiments of this application provides a trans-impedance amplifier TIA control method. The control method includes a plurality of steps as follows: When a conversion rate corresponding to a TIA is a first conversion rate, a first switch in a feedback resistor circuit is controlled to be on. When a conversion rate corresponding to a TIA is a second conversion rate, a first switch in a feedback resistor circuit is controlled to be off. The TIA includes a first inverting amplifier, a second inverting amplifier, a third inverting amplifier, a first voltage clamping circuit, a second voltage clamping circuit, and a third voltage clamping circuit.

The first inverting amplifier, the second inverting amplifier, and the third inverting amplifier are sequentially connected in series. The first voltage clamping circuit is connected in parallel to two ends of the first inverting amplifier. The second voltage clamping circuit is connected in parallel to two ends of the second inverting amplifier. The third voltage clamping circuit is connected in parallel to two ends of the third inverting amplifier. The first inverting amplifier includes a first PMOS transistor and a first NMOS transistor that have a common gate. Gates of the first PMOS transistor and the first NMOS transistor are connected to form an input end of the TIA. A source of the first PMOS transistor is connected to a drain of the first NMOS transistor to form an output end of the first inverting amplifier.

The second inverting amplifier includes a second PMOS transistor and a second NMOS transistor that have a common gate. Gates of the second PMOS transistor and the second NMOS transistor are connected to form an input end of the second inverting amplifier. The input end of the second inverting amplifier is connected to the output end of the first inverting amplifier. A source of the second PMOS transistor is connected to a drain of the second NMOS transistor to form an output end of the second inverting amplifier.

The third inverting amplifier includes a third PMOS transistor and a third NMOS transistor. Gates of the third PMOS transistor and the third NMOS transistor are connected to form an input end of the third inverting amplifier. The input end of the third inverting amplifier is connected to the output end of the second inverting amplifier. A source of the third PMOS transistor is connected to a drain of the third NMOS transistor to form an output end of the TIA.

The first voltage clamping circuit includes a fourth PMOS transistor and a fourth NMOS transistor. Gates of the fourth PMOS transistor and the fourth NMOS transistor are connected to the input end of the TIA. A source of the fourth NMOS transistor and a drain of the fourth PMOS transistor are connected to the output end of the first inverting amplifier. A drain of the fourth NMOS transistor is connected to a direct current power supply, and a source of the fourth PMOS transistor is grounded.

The second voltage clamping circuit includes a fifth PMOS transistor and a fifth NMOS transistor that have a common gate. Gates of the fifth PMOS transistor and the fifth NMOS transistor are connected to the input end of the second inverting amplifier. A source of the fifth NMOS transistor and a drain of the fifth PMOS transistor are connected to the output end of the second inverting amplifier. A drain of the fifth NMOS transistor is connected to the direct current power supply, and a source of the fifth PMOS transistor is grounded.

The third voltage clamping circuit includes a sixth PMOS transistor and a sixth NMOS transistor. Gates of the sixth PMOS transistor and the sixth NMOS transistor are connected to the input end of the third inverting amplifier. A source of the sixth NMOS transistor and a drain of the sixth PMOS transistor are connected to the output end of the TIA. A drain of the sixth NMOS transistor is connected to the direct current power supply, and a source of the sixth PMOS transistor is grounded.

The TIA may further include a feedback resistor circuit. A first end of the feedback resistor circuit is connected to the output end of the TIA. A second end of the feedback resistor circuit is connected to the input end of the TIA. The feedback resistor circuit is configured to convert an input current signal of the TIA into a voltage signal. The feedback resistor circuit includes a first feedback branch, a second feedback branch, and a third feedback branch that are connected in parallel.

The first feedback branch includes a first resistor, a second resistor, and a first switch. The first resistor is connected in series to the second resistor, and the first switch is connected in parallel to two ends of the second resistor. The second feedback branch includes a third resistor and a second switch, and the third resistor is connected in series to the second switch. The third feedback branch includes the fourth resistor and the third switch, and the fourth resistor is connected in series to the third switch.

In an optional implementation, the TIA further includes a first load circuit, a second load circuit, and a third load circuit. The first load circuit includes a first load PMOS transistor, a first load NMOS transistor, a first load switch, and a second load switch. A gate of the first load PMOS transistor is connected to a gate of the first load NMOS transistor. A source of the first load PMOS transistor is connected to a drain of the first load NMOS transistor. The gate of the first load PMOS transistor and the gate of the first load NMOS transistor are connected to the source of the first load PMOS transistor and the drain of the first load NMOS transistor. The gate of the first load PMOS transistor and the gate of the first load NMOS transistor are connected to the output end of the first inverting amplifier. The source of the first load PMOS transistor and the drain of the first load NMOS transistor are connected to the input end of the second inverting amplifier. One end of the first load switch is connected to the direct current power supply, and the other end is connected to a drain of the first load PMOS transistor. One end of the second load switch is connected to a source of the first load NMOS transistor, and the other end is grounded.

The second load circuit includes a second load PMOS transistor, a second load NMOS transistor, a third load PMOS transistor, a third load NMOS transistor, a third load switch, and a fourth load switch. Agate of the second load PMOS transistor is connected to a gate of the second load NMOS transistor. A source of the second load PMOS transistor is connected to a drain of the second load NMOS transistor. The gate of the second load PMOS transistor and the gate of the second load NMOS transistor are connected to the source of the second load PMOS transistor and the drain of the second load NMOS transistor. Agate of the third load PMOS transistor is connected to a gate of the third load NMOS transistor. A source of the third load PMOS transistor is connected to a drain of the third load NMOS transistor. The gate of the third load PMOS transistor and the gate of the third load NMOS transistor are connected to the source of the third load PMOS transistor and the drain of the third load NMOS transistor. The gate of the second load PMOS transistor and the gate of the second load NMOS transistor are connected to the output end of the second inverting amplifier. The source of the second load PMOS transistor and the drain of the second load NMOS transistor are connected to the gate of the third load PMOS transistor and the gate of the third load NMOS transistor. One end of the third load switch is connected to the direct current power supply, and the other end is connected to a drain of the second load PMOS transistor. One end of the fourth load switch is connected to a source of the second load NMOS transistor, and the other end is grounded.

The source of the third load PMOS transistor and the drain of the third load NMOS transistor are connected to the input end of the third inverting amplifier. The third load circuit includes a fourth load PMOS transistor and a fourth load NMOS transistor. A gate of the fourth load PMOS transistor is connected to a gate of the fourth load NMOS transistor. A source of the fourth load PMOS transistor is connected to a drain of the fourth load NMOS transistor. The gate of the fourth load PMOS transistor and the gate of the fourth load NMOS transistor are connected to an output end of the third inverting amplifier. The source of the fourth load PMOS transistor and the drain of the fourth load NMOS transistor are the output end of the TIA.

When the TIA corresponds to a high gain mode, the second switch and the third switch are controlled to be off, and the first load switch, the second load switch, the third load switch, and the fourth load switch are controlled to be off. When the TIA corresponds to a medium gain mode, the second switch is controlled to be on, and the third switch to be off, the first load switch and the second load switch are controlled to be off, and the third load switch and the fourth load switch to be on. When the TIA corresponds to a low gain mode, the second switch and the third switch are controlled to be on, and the first load switch, the second load switch, the third load switch, and the fourth load switch are controlled to be on.

A fourth aspect of embodiments of this application provides a photoelectric converter. The photoelectric converter includes a photoelectric detector and the TIA according to the first aspect or any one of the implementations of the first aspect. Alternatively, the photoelectric converter includes a photoelectric detector and the TIA according to the second aspect or any one of the implementations of the second aspect. An output end of the photoelectric detector is connected to an input end of the TIA. The photoelectric detector is configured to receive an optical signal, and convert the optical signal into a current signal. The TIA is configured to amplify the current signal, and convert the current signal into a voltage signal.

According to the technical solutions disclosed in embodiments of this application, a voltage clamping circuit is connected in parallel to two ends of an operational amplifier of a trans-impedance amplifier, to adjust a voltage at an output end of the trans-impedance amplifier, so that an over-voltage problem of a MOS transistor in the operational amplifier caused by an excessively high or low voltage at an input end is avoided. In this way, a source-drain voltage difference of the MOS transistor can be controlled, to ensure that the MOS transistor is in a safe working state, and improve service life and performance of the trans-impedance amplifier.

### BRIEF DESCRIPTION OF DRAWINGS

FIG. 1 is a system architecture diagram of a passive optical network;
FIG. 2A is a schematic diagram of a structure of a first trans-impedance amplifier according to an embodiment of this application;
FIG. 2B is a schematic diagram of a structure of a second trans-impedance amplifier according to an embodiment of this application;
FIG. 3 is a curve graph of changes in an output voltage according to an embodiment of this application;
FIG. 4A is a schematic diagram of a structure of a first feedback resistor circuit according to an embodiment of this application;
FIG. 4B is a schematic diagram of a structure of a second feedback resistor circuit according to an embodiment of this application;
FIG. 5 is a schematic diagram of a structure of a third trans-impedance amplifier according to an embodiment of this application;
FIG. 6 is a schematic diagram of a structure of a fourth trans-impedance amplifier according to an embodiment of this application;
FIG. 7 is a schematic diagram of a structure of a fifth trans-impedance amplifier according to an embodiment of this application; and
FIG. 8 is a schematic flowchart of a trans-impedance amplifier control method according to an embodiment of this application.

### DESCRIPTION OF EMBODIMENTS

Embodiments of this application provide a trans-impedance amplifier and a trans-impedance amplifier control method. A voltage clamping circuit is connected in parallel to two ends of an operational amplifier included in a TIA, to adjust a voltage at an output end of the trans-impedance amplifier. This avoids an over-voltage problem of a CMOS transistor in the operational amplifier caused by an excessively high or low voltage at an input end. In this way, a source-drain voltage difference of the CMOS transistor can be controlled, to ensure that the CMOS transistor is in a safe working state. Service life and performance of the TIA are improved.

The TIA is a type of amplifier, and is the most important component for converting a current signal into a voltage signal and amplifying the voltage signal. The TIA converts a current to a voltage through a feedback resistor according to the Ohm's law. It has a function of a resistor. The TIA is generally used in high-speed circuits because of its high bandwidth. For example, the TIA is often used in a photoelectric transmission communication system.

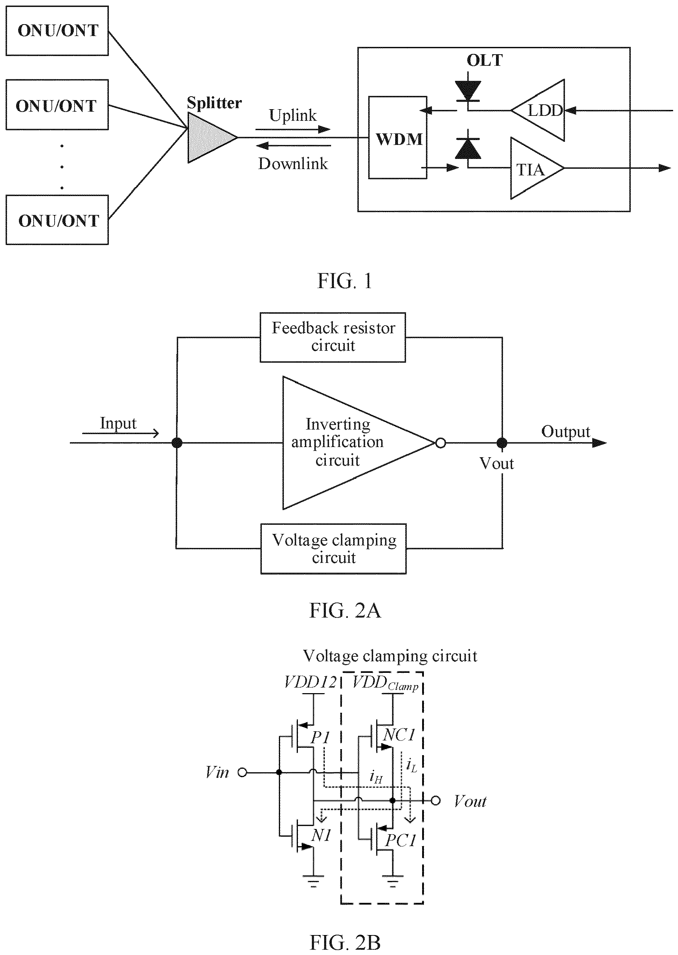

A passive optical network (passive optical network, PON) is used as an example. A TIA is often used in a receiver in the PON to capture an optical signal transmitted in the network. FIG. 1 is a system architecture diagram of a passive optical network. As shown in FIG. 1, the PON is formed by an optical distribution network (optical distribution network, ODN), an optical line terminal (optical line terminal, OLT) on a center office side, and an optical network unit (optical network unit, ONU) on a user side. If the ONU directly provides a user port function, for example, an Ethernet user port function for personal computer PC internet access, the ONU is referred to as an optical network terminal (optical network terminal, ONT). It should be understood that the ONU mentioned below refers to the ONU and the ONT. This is not specifically limited.

The OLT provides a network-side interface for a PON system. The ONU provides a user-side interface for the PON system. The optical distribution network ODN is configured to connect the OLT and the ONU. The ODN is a network formed by an optical fiber and a passive optical splitting device, and is configured to distribute or multiplex a data signal between the OLT and the ONU. In the PON system, transmitting data from the OLT to the ONU is referred to as downlink, and transmitting data from the ONU to the OLT is referred to as uplink.

The PON mainly uses a point-to-multipoint access mode. The OLT establishes a communication link with all ONUs in the PON network through an optical splitter. In uplink transmission, the ONU communicates with the OLT in a time division multiplexing mode. The ONU is turned off when no signal is transmitted, and is quickly turned on when a signal is transmitted. In this way, one communication signal of each ONU is one burst optical signal. This requires that a receiver on an OLT side needs to be capable of quickly capturing burst optical signals within a dynamic range. Insertion loss of links between the OLT and the ONU is different. Therefore, average power and phases of a plurality of burst optical signals arriving at the OLT are different. In this way, the burst optical signal needs to be converted into a voltage signal and the voltage signal needs to be amplified to a same level, to perform a subsequent signal processing process.

An existing TIA includes a PMOS transistor and an NMOS transistor that have a common gate. A source of the PMOS transistor is connected to a drain of the NMOS transistor to form an output end. When a large-current signal enters the TIA, an input voltage of the TIA is excessively high. As a result, an output voltage is excessively low. As a result, a source-drain voltage difference of the PMOS transistor is excessively large, and an over-voltage phenomenon occurs on the PMOS transistor. The voltage difference may exceed a breakdown voltage of the PMOS transistor, causing damage to the PMOS transistor. Similarly, when the input voltage is excessively low, the output voltage is very high. This will result in a large source-drain voltage difference of the NMOS transistor. As a result, an over-voltage phenomenon occurs on the NMOS transistor, and a source-drain voltage exceeds a breakdown voltage of the NMOS transistor, causing damage to the NMOS transistor. Service life and performance of a trans-impedance amplifier are seriously affected.

Based on the foregoing problem, in this embodiment of this application, a voltage clamping circuit is added based on an original TIA structure. The voltage clamping circuit is configured to control a range of the output voltage, so that the output voltage is limited within an appropriate range. In this way, an over-voltage phenomenon of the PMOS transistor and the NMOS transistor caused by an excessively high or low input voltage can be avoided. Therefore, it is ensured that the CMOS transistor inside the TIA is in a safe working state. The service life and working performance of the TIA are improved.

FIG. 2A is a schematic diagram of a structure of a first TIA according to an embodiment of this application. As shown in FIG. 2A, the TIA includes an inverting amplification circuit (inverting amplifier), a voltage clamping circuit, and a feedback resistor circuit. The TIA may be a front-end amplifier of an optical receiver. Two ends of the inverting amplification circuit are an input end and an output end of the TIA. The input end may be connected to a photodiode to receive a current signal. The input end may be connected to a signal processing circuit to perform subsequent signal processing on a converted voltage signal. It may be understood that the TIA is a one-stage amplifier, that is, implements signal amplification once.

The voltage clamping circuit and the feedback resistor circuit are connected in parallel to the two ends of the inverting amplification circuit. The voltage clamping circuit is configured to control an amplitude of an output voltage. The feedback resistor is configured to form a feedback system to convert a current signal into a voltage signal. The inverting amplification circuit may be an inverting amplifier of a CMOS structure. The feedback resistor is connected in parallel to the input and output ends of the inverting amplification circuit. According to a principle of "virtual short and virtual break", if an input current is i, and a resistance corresponding to the feedback resistor circuit is RF, an output voltage Vout is equal to -Rf*i. The inverting amplification circuit may include a PMOS transistor and an NMOS transistor that are connected in series. The PMOS transistor and the NMOS transistor have a common gate, and the gate is an input end of the inverting amplifier. A drain of the PMOS transistor is connected to a power supply, and the power supply provides a drain voltage for the PMOS transistor. A source of the PMOS transistor is connected to a drain of the NMOS transistor to form an output end of the inverting amplifier. The drain of the NMOS transistor may be grounded, or may be connected to a component such as a resistor or an inductor to increase a current function. This is not specifically limited.

An amplification multiple of the inverting amplifier is (gmN + gmP) * (roN//roP). gmN and gmP are transconductances of NMOS and PMOS respectively. roN and roP are leakage output impedances of an NMOS and a PMOS respectively. If the feedback resistor is RF1, the amplification multiple of the entire trans-impedance amplifier is A * Rf1/(1 + A), where A= (gmN + gmP) * (roN//roP). It may be understood that the trans-impedance amplifier is of a single-stage amplifier structure, and a multi-stage amplifier structure may be formed based on the foregoing structure. In other words, the trans-impedance amplifier may include a plurality of inverting amplification circuits connected in series. An output end of a previous inverting amplification circuit is connected to an input end of a next inverting amplification circuit. Finally, a multi-stage amplification trans-impedance amplifier TIA can be obtained by adding a feedback resistor at two ends of the inverting amplifiers connected in series.

FIG. 2B is a circuit diagram of a structure of a second trans-impedance amplifier according to an embodiment of this application. It may be understood that the structure shown in FIG. 2B is an internal circuit diagram of the inverting amplification circuit and the voltage clamping circuit in FIG. 2A. The inverting amplification circuit includes a first PMOS transistor P1 and a first NMOS transistor N1 that have a common gate. Gates of P1 and N1 are connected to form an input end of the inverting amplification circuit. It may be understood that the input end is an input end of the trans-impedance amplifier TIA. A source of P1 is connected to a drain of N1, to form an output end of the inverting amplification circuit. The output end is also an output end of the trans-impedance amplifier TIA. A drain of P1 is configured to connect to a power supply to provide a drain voltage VDD12. A source of N1 may be designed according to a specific situation. The source of N1 may be directly grounded, or may be connected to a resistor, a capacitor, or the like, to implement another circuit function. This is not specifically limited.

The voltage clamping circuit is connected in parallel to two ends of the inverting amplification circuit, and includes a second PMOS transistor PC1 and a second NMOS transistor PC2 that have a common gate. Gates of PC1 and PC2 are connected, and are connected to the input end of the inverting amplification circuit. A drain of NC1 is connected to the power supply to provide a drain voltage *VDD_{Clamp}*. A source of NC1 is connected to a drain of PC1, and is connected to the output end of the inverting amplification circuit. Finally, a source of PC1 is grounded.

Turn-on voltages of NC1 and PC1 are greater than turn-on voltages of P1 and N1. In this way, when a voltage value of an input voltage Vin is within a normal swing range, neither a gate voltage of NC1 nor a gate voltage of PC1 reaches the turn-on voltage. Therefore, NC1 and PC1 are in a cutoff state. In this case, the voltage clamping circuit does not work, and reverse amplification performance of the TIA is not affected. Once Vin is excessively high or low, an on state of a CMOS transistor in the voltage clamping circuit changes. In this way, a voltage value of Vout may be adjusted.

Specifically, a voltage clamping module performs compensation on a load current based on Vin, to control the value of Vout. As shown in the figure, when Vin (gate voltage) is excessively low, the N1 transistor and the NC1 transistor are cut off, and the P1 transistor and the PC1 transistor are turned on. A compensation current *i_{H}* is provided by PC1 to P1. A current direction is from P1 to PC1 and then to the ground. In this way, the voltage value of Vout can be reduced, and it is ensured that Vout is not excessively high. In this way, a drain-source voltage difference of the N1 transistor is not excessively high. This avoids an over-voltage phenomenon to occur on the N1 transistor, and it is ensured that the N1 transistor is in a safe working state. When Vin is excessively high, the P1 transistor and the PC1 transistor are cut off, and the N1 transistor and the NC1 transistor are turned on. A compensation current *i_{L}* is provided by NC1 to N1, and the current direction is from NC1 to N1 and then to the ground. In this way, the voltage value of Vout can be increased, and it is ensured that Vout is not excessively low. In this way, a drain-source voltage difference of the P1 transistor is not excessively high. This avoids an over-voltage phenomenon on the P1 transistor, and it is ensured that the P1 transistor is in a safe working state.

In the foregoing TIA, the voltage clamping module may perform compensation for a load circuit based on a voltage at the input end. The output voltage is protected and controlled within a normal range. In this way, an over-voltage phenomenon of the CMOS transistor caused by an excessively large drain-source voltage difference of the CMOS transistor is avoided, and it is ensured that the CMOS transistor is in the safe working state. This prevents deviation of a working point from a breakdown point due to a sudden change of a current signal, which may damage the CMOS transistor. The performance of the TIA is improved. In addition, the voltage clamping module has advantages such as a fast response speed, and can process an instantaneous change in node voltages caused by a burst signal. Therefore, stability of the TIA is improved.

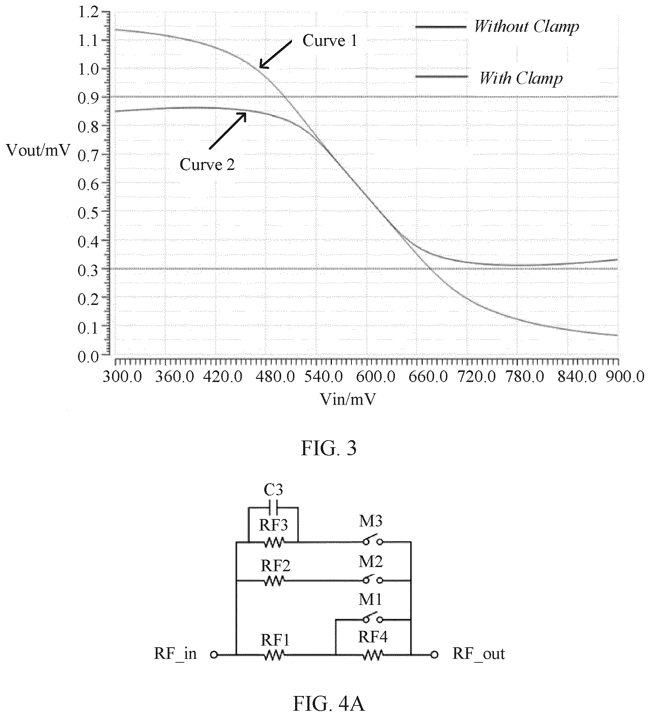

FIG. 3 is a curve graph of changes in an output voltage according to an embodiment of this application. As shown in FIG. 3, a horizontal coordinate represents a voltage value of an input voltage Vin, and a vertical coordinate represents a voltage value of an output voltage Vout. A curve 1 is a change curve of Vout that changes along with Vin when no voltage clamping circuit is connected. A curve 2 is a change curve of Vout that changes along with Vin after a voltage clamping circuit is connected.

It can be learned from FIG. 3 that when the input voltage Vin is at a normal working point 600 mV, Vout corresponding to the curve 1 and the curve 2 does not change. That is, when Vin is within a normal working swing, the voltage clamping circuit does not affect a gain of a TIA. Then, as a range of the input voltage Vin is expanded (increased or decreased), a range of Vout corresponding to the TIA that is not connected to the voltage clamping circuit becomes large. This easily causes an over-voltage phenomenon of a CMOS transistor. Vout of the TIA that is connected to the voltage clamping circuit is limited within a range of 300 mV to 900 mV. The voltage is not excessively high or excessively low, to ensure that transistors inside the trans-impedance amplifier are in a safe working state.

The gain of the TIA is described for a feedback resistor circuit below. The feedback resistor circuit is configured to convert an input current signal into a voltage signal. It can be learned from the foregoing descriptions that an amplification multiple (a gain) of the trans-impedance amplifier is A * Rf1/(1 + A), where A = (gmN + gmP) * (roN//roP). According to the formula, the gain is related to a resistance of a feedback resistor, a transconductance of the CMOS transistor, and a leakage output impedance. The larger the resistance of the feedback resistor is, the higher the gain of the trans-impedance amplifier is. Therefore, the feedback resistor circuit may be designed to control the resistance of the feedback resistor to change. In this way, the gain of the trans-impedance amplifier is changed.

In addition, the feedback resistor circuit may be designed to adjust a conversion rate of the trans-impedance amplifier. The conversion rate is an important indicator of an operational amplifier, and is used to measure an ability of the operational amplifier to restore details. The conversion rate is defined as that after the operational amplifier is connected into a closed-loop system, a large signal is input to an input end of the operational amplifier, and an output rising rate of the operational amplifier is measured at an output end of the operational amplifier. When the input signal changes excessively fast, due to a limitation of an RC time constant inside the operational amplifier, the output end cannot change with the input end. Generally, the conversion rate can be adjusted by designing the feedback resistor circuit.

FIG. 4A is a schematic diagram of a structure of a first feedback resistor circuit according to an embodiment of this application. As shown in FIG. 4A, the feedback resistor circuit is connected in parallel to two ends of an inverting amplifier. That is, between an input end and an output end of a TIA, the feedback resistor circuit includes three parallel feedback branches. A first feedback branch includes resistors RF1 and RF4 that are connected in series. A switch M1 is connected in parallel to two ends of RF4. A second feedback branch includes a resistor RF2 and a switch M2. The resistor RF2 is connected in series to the switch M2. A third feedback branch includes a resistor RF3 and a switch M3. The resistor RF3 is connected in series to M3.

The feedback resistor circuit can provide switching between two conversion rates and three gain modes. For example, when a conversion rate of the trans-impedance amplifier needs to be controlled to be a first conversion rate, for example, 10 G, the switch M1 on the first feedback branch may be on. In this way, only RF1 exists on the first feedback branch. When the conversion rate of the trans-impedance amplifier needs to be controlled to be a second conversion rate, for example, 2.5 G, the switch M1 on the first feedback branch is controlled to be off. In this way, the first feedback branch includes RF1 and RF4, to implement switching between the two conversion rates.

In addition, on/off states of the switch M2 on the second feedback branch and the switch M3 on the third feedback branch are controlled to implement switching between different gain modes. If the trans-impedance amplifier requires a high gain mode, both the switch M2 on the second feedback branch and the switch M3 on the third feedback branch may be controlled to be off. In this way, a resistance of an entire feedback loop is a resistance of RF1 or a resistance obtained after RF1 and RF4 are connected in serial. In this case, a resistance of a feedback resistor is the largest, and a corresponding gain is the highest.

If the trans-impedance amplifier requires a medium gain mode, the switch M2 on the second feedback branch may be controlled to be on, and the switch M3 on the third feedback branch may be controlled to be off. In this way, the resistance of the entire feedback loop is a resistance obtained after RF1 and RF2 are connected in parallel, or a resistance obtained after RF1 and RF4 are first connected in series and then connected in parallel to RF2. It may be understood that the more the resistors are connected in parallel, the smaller the resistance is. Therefore, parallel connection of RF2 on the second feedback branch to the feedback loop causes a decrease in the resistance of the feedback resistor. The corresponding gain also decreases.

When the trans-impedance amplifier requires a low gain mode, both the switch M2 on the second feedback branch and the switch M3 on the third feedback branch may be controlled to be on. In this way, the resistance of the entire feedback loop is a resistance obtained after RF1, RF2, and RF3 are connected in parallel, or a resistance obtained after RF1 and RF4 are first connected in series and then connected in parallel to RF2 and RF3. In this case, the resistance of the feedback resistor is the smallest, and the corresponding gain is the lowest. In a process of gain reduction, a main pole of an open loop increases due to the decrease in the resistance of the feedback resistor. This causes a decrease in loop stability. Therefore, a feedback capacitor C3 may be added on the third feedback branch, so that the feedback capacitor C3 can be connected in parallel to two sides of RF3 to compensation for a phase margin.

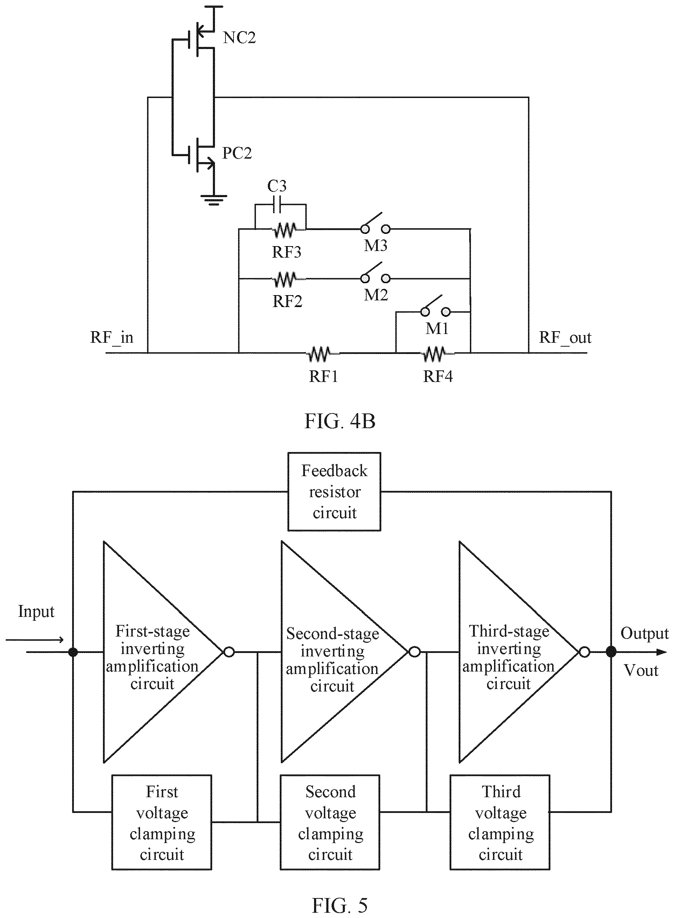

In a preferred solution, two ends of the feedback resistor circuit may also be connected to a voltage clamping circuit, to control an input voltage. FIG. 4B is a schematic diagram of a structure of a second feedback resistor circuit according to an embodiment of this application. As shown in FIG. 4B, two ends of the feedback resistor circuit are connected to another voltage clamping circuit. The voltage clamping circuit is formed by an NMOS transistor NC2 and a PMOS transistor PC2. Gates of NC2 and PC2 are connected, and are connected to an input end of the feedback resistor circuit. A source of NC2 is connected to a drain of PC2, and is connected to an output end of the feedback resistor circuit. A drain of NC2 is connected to a drain power supply, and a source of PC2 is grounded.

Because the voltage clamping circuit is connected to a feedback branch, the voltage clamping circuit can clamp a voltage Vin at the input end. A specific principle is similar to a principle of the foregoing voltage clamping circuit, and details are not described herein again. A value of Vin can be controlled by clamping the voltage Vin at the input end. In this way, a value of Vout can be effectively controlled, so that source-drain voltage differences of the PMOS transistor and the NMOS transistor are not excessively large. In this way, breakdown of the two transistors can be avoided, and service life and working performance of the PMOS transistor and the NMOS transistor are improved.

A load circuit of a trans-impedance amplifier is described below. It should be understood that an output end of an operational amplifier may be further connected to a load circuit, to adjust a gain of a TIA. For example, the load circuit may be formed by a resistor to change a leakage output impedance. Preferably, the resistor may be replaced by a load CMOS transistor, and the load CMOS transistor functions as a resistor with an adjustable resistance. For example, the load circuit includes a load PMOS transistor and a load NMOS transistor. A gate of the load PMOS transistor is connected to a gate of the load NMOS transistor to form an input end of the load circuit. A source of the load PMOS transistor is connected to a drain of the load NMOS transistor. The gate of the load PMOS transistor and the gate of the load NMOS transistor are connected to the source of the load PMOS transistor and the drain of the load NMOS transistor, so that the two transistors are connected in parallel. Again of an inverting amplification circuit can be adjusted by using the load PMOS transistor and the NMOS transistor.

The load circuit may further include a load capacitor, configured to adjust an open-loop bandwidth of the inverting amplification circuit. Specifically, one end of the load capacitor is connected to the source of the load PMOS transistor and the drain of the load NMOS transistor. The other end of the load capacitor is grounded, to improve performance of the entire trans-impedance amplifier.

The trans-impedance amplifier described in the foregoing embodiments is a one-stage amplifier. Based on the foregoing structure, a multi-stage amplification trans-impedance amplifier may be further formed. A three-stage amplifier is used as an example for description below. It may be understood that for a structure of a multi-stage amplifier such as a five-stage amplifier or a seven-stage amplifier, refer to a structure of the three-stage amplifier. Working principles are similar, and details are not described herein again.

FIG. 5 is a schematic diagram of a structure of a third trans-impedance amplifier according to an embodiment of this application. As shown in FIG. 5, the TIA is of a three-stage amplification structure, that is, includes three inverting amplifiers (inverting amplification circuits) connected in series. An output of a previous inverting amplifier is an input of a next inverting amplifier. When a current signal is transmitted to a first-stage inverting amplifier, the first-stage inverting amplifier converts the current signal into a voltage signal, and transmits the voltage signal to a second-stage inverting amplifier for reverse amplification. Then, the signal is transmitted to a third-stage inverting amplifier through the second-stage inverting amplifier for reverse amplification. A total gain of the trans-impedance amplifier is a product of amplification multiples corresponding to the inverting amplifiers.

Each stage of inverting amplifier corresponds to a voltage clamping circuit. That is, the trans-impedance amplifier includes three voltage clamping circuits. Each voltage clamping circuit is connected in parallel to two ends of each stage of inverting amplifier, and is configured to limit a voltage value of an output voltage of each stage of inverting amplifier. It is ensured that a CMOS transistor included in each stage of inverting amplifier is in a safe working state, to prevent the CMOS transistor in each stage of amplifier from being damaged due to an over-voltage phenomenon. It may be understood that for control of the voltage clamp circuit on the output voltage of each stage of inverting amplifier, refer to an amplitude limiting principle of the voltage clamp circuit in the foregoing single-stage amplifier, and details are not described herein again.

The three-stage amplification trans-impedance amplifier further includes a feedback resistor circuit. The feedback resistor circuit is connected in parallel between an output end of the first-stage inverting amplifier and an input end of the third-stage inverting amplifier, and is configured to convert a current signal into a voltage signal. For example, an internal structure of the feedback resistor circuit may be the same as a structure of the feedback resistor circuit in the embodiments shown in FIG. 4A and FIG. 4B, and includes a plurality of feedback branches that are connected in parallel. A resistance of the feedback resistor circuit is controlled by connecting the feedback branches in parallel and disconnecting the feedback branches, thereby affecting a gain of the entire trans-impedance amplifier and providing a plurality of gain modes.

Each stage of inverting amplifier may be further connected to a load circuit. The output end of the first-stage inverting amplifier is connected to an input end of a first load circuit, and an output end of the first load circuit is connected to an input end of the second-stage inverting amplifier. An output end of the second-stage inverting amplifier is connected to an input end of a second load circuit, and an output end of the second load circuit is connected to the input end of the third-stage inverting amplifier. An output end of the third-stage inverting amplifier is connected to an input end of a third load circuit, and an output end of the third load circuit is an output end of the entire trans-impedance amplifier.

In the three-stage amplification trans-impedance amplifier, each stage of load circuit is also configured to adjust the gain of the trans-impedance amplifier. Similarly, the load circuit may be formed by a resistor to change a leakage output impedance. The load circuit may be formed by a load CMOS transistor, and the load CMOS transistor functions as a resistor with an adjustable resistance, and is used to adjust the gain of the trans-impedance amplifier. The load circuit may further include a load capacitor, configured to adjust a bandwidth of the trans-impedance amplifier.

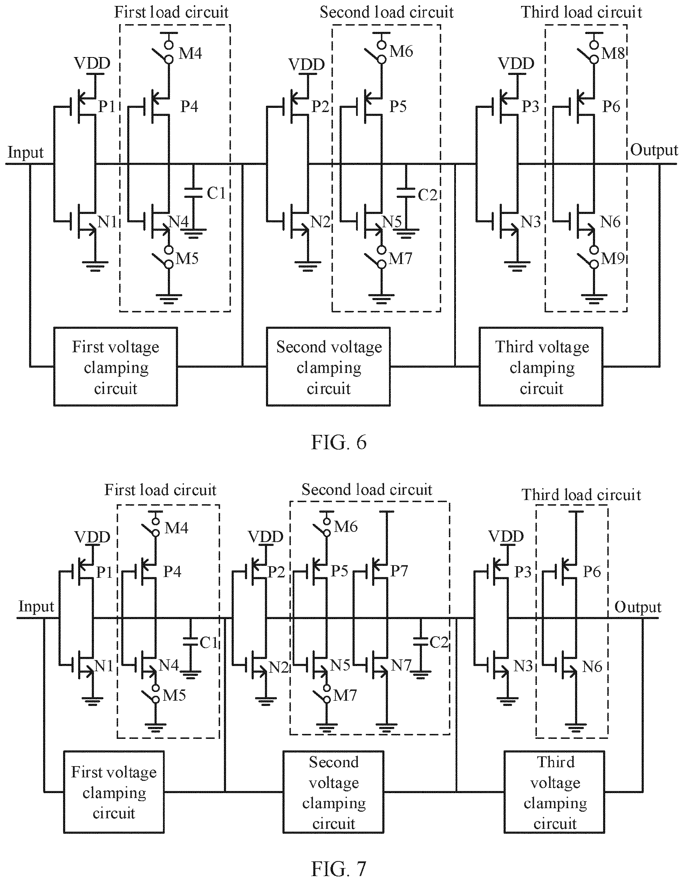

Based on the foregoing descriptions, for the three-stage amplification trans-impedance amplifier, a circuit structure of each stage may be exactly the same. FIG. 6 is a schematic diagram of a structure of a fourth trans-impedance amplifier according to an embodiment of this application. As shown in FIG. 6, the TIA is of a three-stage amplification structure. In each stage of amplification structure, an inverting amplifier is formed by a PMOS transistor and an NMOS transistor. A load circuit is formed by a switch, a PMOS transistor, an NMOS transistor, and a load capacitor, and a structure of each stage is the same.

In a first-stage amplification structure, a first inverting amplifier includes a PMOS transistor P1 and an NMOS transistor N1 that have a common gate. Gates of P1 and N1 are connected to form an input end of the trans-impedance amplifier. A drain of P1 is connected to a power supply, and the power supply provides a drain voltage for P1. A source of P1 is connected to a drain of N1, to form an output end of the first inverting amplifier. A source of N1 may be grounded.

The output end of the first inverting amplifier is configured to connect to the first load circuit. For example, the first load circuit includes a load PMOS transistor P4 and a load NMOS transistor N4. Gates of P4 and N4 are interconnected, and are connected to the output end of the first inverting amplifier. A source of P4 is connected to a drain of N4, and is connected to the gates of P4 and N4. In this way, a parallel structure is formed. In addition, a drain of P4 is connected to a switch M4, and is connected to a drain power supply through the switch M4. A source of N4 is connected to a switch M5, and is grounded through the switch M5.

In addition, the first load circuit further includes a load capacitor C1. One end of the load capacitor C1 is grounded, and the other end is connected to the source of P4. The source of P4 is connected to the drain of N4 to form an output end of the first load circuit, and the output end is connected to an input end of a second-stage amplification structure. In addition, the first-stage amplification structure includes a first voltage clamping circuit, and the first voltage clamping circuit is connected in parallel to two ends of the first-stage amplification structure, to resolve an over-voltage problem in the circuit. For an internal structure of the first voltage clamping circuit, refer to the structure of the voltage clamping circuit in the embodiment shown in FIG. 2B. Details are not described herein again.

Similarly, the second-stage amplification structure is exactly the same as the first-stage amplification structure. The second-stage amplification structure also includes a second inverting amplifier, a second load circuit, and a second voltage clamping circuit. The second voltage clamping circuit is connected in parallel between an input end of the second inverting amplifier and an output end of the second load circuit. For a specific internal structure of each part, refer to a structure of each part in the first-stage amplification structure. Details are not described herein again. A third-stage amplification structure is also exactly the same as the first-stage amplification structure and the second-stage amplification structure, and includes a third inverting amplifier, a third load circuit, and a third voltage clamping circuit. The third voltage clamping circuit is connected in parallel between an input end of the third inverting amplifier and an output end of the third load circuit. For an internal structure, refer to the description in the first-stage amplification structure. Details are not described herein again.

It should be understood that a feedback resistor circuit is further connected in parallel between an output end and the input end of the trans-impedance amplifier. A structure of the feedback resistor circuit is the same as that of the feedback resistor circuit shown in FIG. 4A or FIG. 4B. Switching between two conversion rates and three gain modes of the trans-impedance amplifier can be implemented by controlling switches in the feedback resistor circuit and switches in three load circuits.

When the trans-impedance amplifier of the three-stage structure needs to be switched to a first conversion rate, for example, 10 G, a switch M1 on a first feedback branch may be on. In this way, only RF1 exists on the first feedback branch. When the conversion rate of the trans-impedance amplifier needs to be controlled to be a second conversion rate, for example, 2.5 G, the switch M1 on the first feedback branch is controlled to be off. In this way, the first feedback branch includes RF1 and RF4, to implement switching between the two conversion rates.

When the trans-impedance amplifier is at the first conversion rate, the switch M1 on the first feedback branch is off. In this case, the switching of the gain mode at the first conversion rate may be implemented by controlling an on/off state of another switch. Specifically, if the trans-impedance amplifier needs to switch to a high gain mode, both a switch M2 on a second feedback branch and a switch M3 on a third feedback branch may be controlled to be off. In addition, switches M4 and M5 in a first-stage load circuit, switches M6 and M7 in a second-stage load circuit, and switches M8 and M9 in a third-stage load circuit are all controlled to be off. In this way, a resistance of the load circuit is the maximum, a resistance of a feedback resistor of a feedback circuit is also the maximum, and therefore, the gain is the highest. This corresponds to the high gain mode.

If the trans-impedance amplifier needs to switch to a medium gain mode, the switch M2 on the second feedback branch may be controlled to be on. The switch M3 on the third feedback branch is controlled to be off. In addition, the switches M4 and M5 in the first load circuit are controlled to be off. The switches M6 and M7 in the second-stage load circuit and the switches M8 and M9 in the third-stage load circuit are controlled to be on. In this way, because RF2 is connected in parallel to RF1, the resistance of the feedback resistor of the feedback circuit decreases. In addition, in the load circuit, PMOS transistors and NMOS transistors included in the second load circuit and the third load circuit are connected in parallel, which causes a decrease in the resistance of the load circuit. As a result, the gain of the TIA also decreases. This corresponds to the medium gain mode.

If the trans-impedance amplifier needs to switch to a low gain mode, both the switch M2 on the second feedback branch and the switch M3 on the third feedback branch may be controlled to be on. In addition, the switches M4 and M5 in the first load circuit, the switches M6 and M7 in the second load circuit, and the switches M8 and M9 in the third load circuit are all controlled to be on. In this way, the feedback circuit is connected to RF3 in parallel again, and consequently the resistance of the feedback resistor decreases again. In addition, in the load circuit, the PMOS transistor and the NMOS transistor of the first load circuit are connected in parallel, which causes the resistance of the load circuit to decrease again. In this way, the gain of the TIA is the lowest. This corresponds to the low gain mode. In addition, load capacitors C1 and C2 can be added in the low gain mode to adjust a bandwidth.

Similarly, when the trans-impedance amplifier is at the second conversion rate, that is, the switch M1 on the first feedback branch is on, switching between the three gain modes at the conversion rate may also be implemented through the foregoing method. The control method is similar to the control method for gain mode switching at the first conversion rate, and is not described herein again.

In the trans-impedance amplifier, switching between two conversion rates and three gain modes can be implemented by controlling the switches in the feedback resistor circuit and the load circuit. This greatly improves working flexibility of the TIA, and in this way, parameters of the TIA can be adjusted according to a specific requirement, thereby improving performance of the TIA.

In the TIA, P6 and N6 in the third load circuit correspond to the switches M7 and M8. A connection manner of P6 and N6 may be controlled by controlling on/off states of M7 and M8. However, when the connection manner is changed, a resistance corresponding to the third load circuit is also affected. Because a control circuit needs to be connected behind the third load circuit, the resistance of the third load circuit directly affects a steady state of the control circuit. Resistance fluctuation causes instability of a next-stage circuit. To resolve the foregoing problem, FIG. 7 shows a schematic diagram of a structure of a fifth trans-impedance amplifier according to an embodiment of this application. As shown in FIG. 7, the trans-impedance amplifier is of a three-stage amplification structure, and includes three inverting amplifiers (first to third inverting amplifiers), three voltage clamping circuits (first to third voltage clamping circuits), and three load circuits (first to third load circuits).

An input end of the first inverting amplifier is an input end of the trans-impedance amplifier. An output end of the first reverse amplifier is connected to an input end of the first load circuit. An output end of the first load circuit is connected to an input end of the second inverting amplifier. An output end of the second inverting amplifier is connected to an input end of the second load circuit. An output end of the second load circuit is connected to an input end of the third inverting amplifier. An output end of the third inverting amplifier is connected to an input end of the third load circuit. An output end of the third load circuit is an output end of the trans-impedance amplifier.

The first voltage clamping circuit is connected in parallel between the input end of the first inverting amplifier and the output end of the first load circuit. The second voltage clamping circuit is connected in parallel between the input end of the second inverting amplifier and the output end of the second load circuit. The third voltage clamping circuit is connected in parallel between the input end of the third inverting amplifier and the output end of the third load circuit.

Structures of the first to third inverting amplifiers are similar to structures of the first to third inverting amplifiers in the embodiment shown in FIG. 6, and details are not described herein again. The first voltage clamping circuit, the second voltage clamping circuit, and the third voltage clamping circuit are further configured to limit a voltage value of an output voltage of each stage of inverting amplifier, ensure that a CMOS transistor included in each stage of inverting amplifier is in a safe working state, and prevent component damage caused by an over-voltage phenomenon to the CMOS transistor in each stage of amplifier. It may be understood that for a structure of the voltage clamping circuit and control of the output voltage of each stage of inverting amplifier, refer to the amplitude limiting principle of the voltage clamping circuit in the single-stage amplifier. Details are not described herein again.

A structure of the load circuit corresponding to the embodiment shown in FIG. 7 slightly differs from that in the embodiment shown in FIG. 6. Specifically, in the embodiment shown in FIG. 7, the first load circuit includes a load PMOS transistor P4 and a load NMOS transistor N4. Gates of P4 and N4 are interconnected, and are connected to the output end of the first inverting amplifier. A source of P4 is connected to a drain of N4, and is connected to the gates of P4 and N4. In addition, a drain of P4 is connected to a switch M4, and is connected to a drain power supply through the switch M4. A source of N4 is connected to a switch M5, and is grounded through the switch M5. The first load circuit further includes a load capacitor C1. One end of the load capacitor C1 is grounded, and the other end is connected to the source of P4. The source of P4 is connected to the drain of N4 to form the output end of the first load circuit. The output end is connected to the input end of the second reverse amplifier.

The second load circuit includes a load PMOS transistor P5 and a load NMOS transistor N5, and a load PMOS transistor P7 and a load NMOS transistor N7. Gates of P5 and N5 are interconnected, and connected to the output end of the second inverting amplifier. A source of P5 is connected to a drain of N5, and is connected to the gates of P5 and N5. In addition, a drain of P5 is connected to a switch M6, and is connected to the drain power supply through the switch M6. A source of N5 is connected to a switch M7, and is grounded through the switch M7.

Gates of P7 and N7 are interconnected, and are connected to the source of P5 and the drain of N5. A source of P7 is connected to a drain of N7, and is connected to the gates of P7 and N7. In addition, a drain of P7 is connected to the drain power supply, and N7 is grounded. In addition, the second load circuit further includes a load capacitor C2. One end of the load capacitor C2 is grounded, and the other end is connected to the source of P7 and the drain of N7. The source of P7 is connected to the drain of N7 to form the output end of the second load circuit. The output end is connected to the input end of the third-stage inverting amplifier.

The third load circuit includes a load PMOS transistor P6 and a load NMOS transistor N6. Gates of P6 and N6 are interconnected, and connected to the output end of the third inverting amplifier. A source of P6 is connected to a drain of N6, and is connected to the gates of P6 and N6, to form a parallel structure. In addition, P6 is connected to the drain power supply, and a source of N6 is grounded. The source of P6 is connected to the drain of N6 to form the output end of the third load circuit. The output end is also the output end of the entire trans-impedance amplifier.

In the above structure, a resistance corresponding to the third load circuit is fixed. Therefore, if the TIA needs to switch to a high gain mode, both a switch M2 on a second feedback branch and a switch M3 on a third feedback branch may be controlled to be off. In addition, switches M4 and M5 in the first-stage load circuit and switches M6 and M7 in the second-stage load circuit are controlled to be off. In this way, a resistance of the load circuit is the maximum, and a resistance of a feedback resistor of a feedback circuit is also the maximum. Therefore, the gain is the highest. This corresponds to the high gain mode.

If the TIA needs to switch to a medium gain mode, the switch M2 on the second feedback branch may be controlled to be on and the switch M3 on the third feedback branch may be controlled to be off. In addition, the switches M4 and M5 in the first load circuit are controlled to be off, and the switches M6 and M7 in the second load circuit are controlled to be on. In this way, because RF2 is connected in parallel to RF1, the resistance of the feedback resistor of the feedback circuit decreases. In addition, in the load circuit, PMOS transistors and NMOS transistors included in the second load circuit and the third load circuit are connected in parallel. In this way, the resistance of the load circuit decreases, and therefore the gain also decreases. This corresponds to the medium gain mode.

If the TIA needs to switch to a low gain mode, the switch M2 on the second feedback branch and the switch M3 on the third feedback branch may be controlled to be on. In addition, the switches M4 and M5 in the first load circuit and the switches M6 and M7 in the second load circuit are controlled to be on. In this way, the feedback circuit is connected to RF3 in parallel again, and consequently the resistance of the feedback resistor decreases again. In addition, in the load circuit, the PMOS transistor and the NMOS transistor of the first load circuit are connected in parallel, which causes the resistance of the load circuit to decrease again. As a result, the gain is the lowest. This corresponds to the low gain mode. In addition, load capacitors C1 and C2 can be added in the low gain mode to adjust a bandwidth.

In the TIA of the foregoing three-stage amplification structure, because the load PMOS transistor and the load NMOS transistor in the third load circuit are fixed, a corresponding output impedance is fixed. In this way, a subsequently connected control circuit is in a steady state. In addition, switching between the three gain modes may alternatively be performed by controlling the switches in the first load circuit and the second load circuit. Therefore, performance of the TIA is better, and stability of the trans-impedance amplifier is improved.

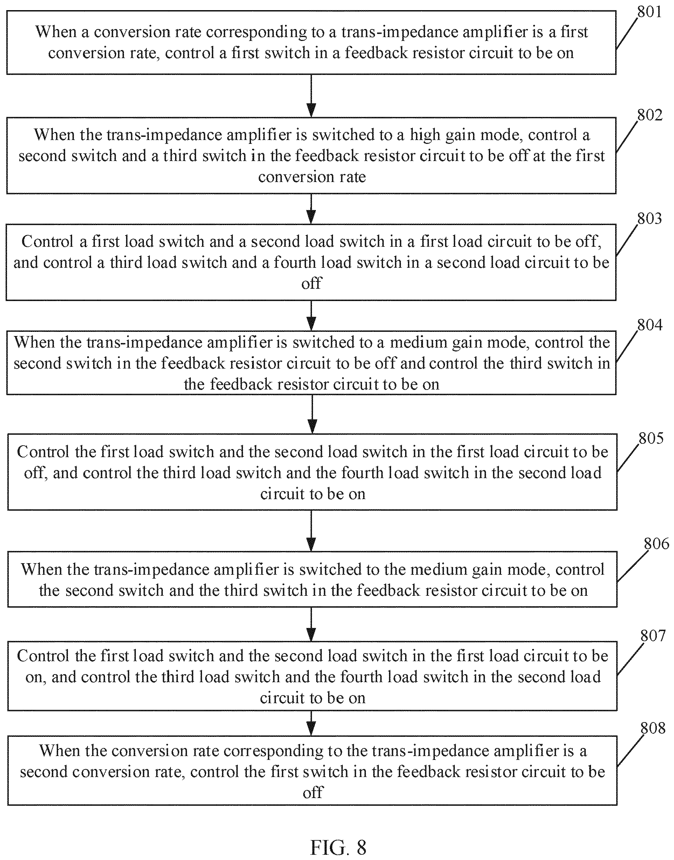

With reference to a diagram of a circuit structure of the trans-impedance amplifier shown in FIG. 7, FIG. 8 is a schematic flowchart of a trans-impedance amplifier control method according to an embodiment of this application. As shown in FIG. 8, the control method includes the following steps.

801: When a conversion rate corresponding to a trans-impedance amplifier is a first conversion rate, control a first switch in a feedback resistor circuit to be on.

For a structure of the trans-impedance amplifier, refer to the structure of the trans-impedance amplifier in the embodiment shown in FIG. 7. For a structure of the feedback resistor circuit, refer to the structure of the feedback resistor in the embodiment shown in FIG. 4A or FIG. 4B. The first conversion rate is greater than a second conversion rate. For example, the first conversion rate may be 10 G, and the second conversion rate may be 2.5 G. A switch M1 on a first feedback branch in the feedback resistor circuit may be used to implement switching of the conversion rate. Specifically, when the conversion rate corresponding to the trans-impedance amplifier is 10 G, M1 may be on, so that only a feedback resistor RF1 exists on the first feedback branch.

802: When the trans-impedance amplifier is switched to a high gain mode, control a second switch and a third switch in the feedback resistor circuit to be off at the first conversion rate state.

When the conversion rate of the trans-impedance amplifier is fixed, a gain mode may be switched by controlling switches on a second feedback branch and a third feedback branch and a switch in a load circuit. When the trans-impedance amplifier is switched to the high gain mode, a resistance of the feedback resistor circuit needs to reach the maximum. Therefore, both a switch M2 on the second feedback branch and a switch M3 on the third feedback branch need to be off, so that only RF1 exists in the feedback resistor circuit.

803: Control a first load switch and a second load switch in a first load circuit to be off, and control a third load switch and a fourth load switch in a second load circuit to be off, to complete switching to the high gain mode.

In addition, switches in the first load circuit and the second load circuit also need to be controlled. Specifically, switches M4 and M5 in the first load circuit need to be off. Switches M6 and M7 in the second load circuit need to be off. In this way, a load in each stage of load circuit reaches the maximum. In this way, a gain of the entire trans-impedance amplifier is the highest, and the high-gain mode is reached.

804: When the trans-impedance amplifier is switched to a medium gain mode, control the second switch in the feedback resistor circuit to be off and control the third switch in the feedback resistor circuit to be on.

The gain of the TIA in the medium gain mode is less than the gain of the TIA in the high gain mode. Therefore, the resistance of the feedback resistor circuit and a resistance of the load circuit need to be reduced. In this case, the switch M2 on the second feedback branch in the feedback resistor circuit may be on. The switch M3 on the third feedback branch is off, so that RF1 is connected in parallel to RF2. In this way, the resistance corresponding to the feedback resistor circuit decreases, and the gain decreases.

805: Control the first load switch and the second load switch in the first load circuit to be off, and control the third load switch and the fourth load switch in the second load circuit to be on, to complete switching to the medium gain mode.

In addition, a switch in the load circuit needs to be adjusted. Specifically, the switches M4 and M5 in the first load circuit need to be off, and the switches M6 and M7 in the second load circuit need to be on. In this way, a load in the second load circuit is reduced, so that the gain of the entire trans-impedance amplifier is decreased, and the medium gain mode is reached.

806: When the trans-impedance amplifier is switched to the medium gain mode, control the second switch and the third switch in the feedback resistor circuit to be on.

The gain of the trans-impedance amplifier in the low gain mode is the minimum. Therefore, the resistance of the feedback resistor circuit and the resistance of the load circuit need to be further reduced. In this case, both the switch M2 on the second feedback branch and the switch M3 on the third feedback branch in the feedback resistor circuit may be on. In this way, RF1 to RF3 are connected in parallel, the resistance of the feedback resistor circuit decreases, and the gain decreases.

807: Control the first load switch and the second load switch in the first load circuit to be on, and control the third load switch and the fourth load switch in the second load circuit to be on, to complete switching to the low gain mode.

In addition, the switch in the load circuit needs to be adjusted. Specifically, the switches M4 and M5 in the first load circuit and the switches M6 and M7 in the second load circuit need to be on. In this way, a load in the first load circuit is reduced, so that the gain of the entire trans-impedance amplifier is further reduced, and the low gain mode is reached.

808: When the conversion rate corresponding to the trans-impedance amplifier is the second conversion rate, control the first switch in the feedback resistor circuit to be off.

The switch M1 on the first feedback branch in the feedback resistor circuit may be used to implement switching of the conversion rate. Therefore, when the conversion rate of the trans-impedance amplifier needs to be switched from the first conversion rate to the second conversion rate, for example, when the conversion rate of the trans-impedance amplifier needs to be switched from 10 G to 2.5 G, M1 may be off. In this way, RF1 and RF4 exist on the first feedback branch. It may be understood that after the conversion rate corresponding to the trans-impedance amplifier is switched to the second conversion rate, gain mode switching at the second conversion rate may also be completed according to the foregoing steps. The control manner is similar, and details are not described herein.

According to the foregoing trans-impedance amplifier control method, a switch in a feedback resistor circuit and a switch in a load circuit are controlled, so that a plurality of conversion rates of a trans-impedance amplifier can be implemented, thereby improving flexibility and working performance of the trans-impedance amplifier.

An embodiment of this application further provides a photoelectric converter, including a trans-impedance amplifier and a photoelectric detector. For a structure of the trans-impedance amplifier, refer to the structure of the trans-impedance amplifier in any one of the foregoing embodiments. Details are not limited.

An output end of the photoelectric detector is connected to an input end of the TIA. The photoelectric detector is configured to receive an optical signal, and convert the optical signal into a current signal. The TIA is configured to amplify the current signal, and convert the current signal into a voltage signal.

The technical terms used in embodiments of the present invention are merely used to describe specific embodiments, but are not intended to limit the present invention. In this specification, singular forms "one", "this", and "the" are intended to simultaneously include plural forms unless otherwise clearly specified in the context. Further, the term "including" and/or "containing" used in this specification refers to presence of features, entirety, steps, operations, elements and/or components, but does not exclude presence or addition of one or more other features, entirety, steps, operations, elements and/or components.

In the appended claims, the corresponding structures, materials, actions, and equivalent forms (if any) of all apparatuses or steps and functional elements are intended to include any structure, material, or action that is used to perform the function with reference to other explicitly required elements. The descriptions of the present invention are given for the purposes of the embodiments and the descriptions, but are not intended to be exhaustive or limit the present invention to the disclosed form.

## Claims

1. A trans-impedance amplifier TIA, wherein the TIA comprises an inverting amplification circuit and a first voltage clamping circuit, wherein
the inverting amplification circuit is connected in parallel to the first voltage clamping circuit;
the inverting amplification circuit comprises a first PMOS transistor and a first NMOS transistor that have a common gate, gates of the first PMOS transistor and the first NMOS transistor are connected to form an input end of the TIA, and a source of the first PMOS transistor is connected to a drain of the first NMOS transistor to form an output end of the inverting amplification circuit; and
the first voltage clamping circuit comprises a second PMOS transistor and a second NMOS transistor that have a common gate, gates of the second PMOS transistor and the second NMOS transistor are connected to the input end of the TIA, a source of the second NMOS transistor and a drain of the second PMOS transistor are connected to an output end of the TIA, a drain of the second NMOS transistor is connected to a direct current power supply, and a source of the second PMOS transistor is grounded.

2. The TIA according to claim 1, wherein turn-on voltages of the first PMOS transistor and the first NMOS transistor are both less than turn-on voltages of the second PMOS transistor and the second NMOS transistor.

3. The TIA according to claim 1 or 2, wherein the TIA further comprises a feedback resistor circuit, the feedback resistor circuit is connected in parallel to the inverting amplification circuit, and the feedback resistor circuit is configured to convert an input current signal of the TIA into a voltage signal.

4. The TIA according to claim 3, wherein the feedback resistor circuit comprises a first feedback branch, a second feedback branch, and a third feedback branch that are connected in parallel;
the first feedback branch comprises a first resistor, a second resistor, and a first switch, the first resistor is connected in series to the second resistor, and the first switch is connected in parallel to two ends of the second resistor;
the second feedback branch comprises a third resistor and a second switch, and the third resistor is connected in series to the second switch; and
the third feedback branch comprises a fourth resistor and a third switch, and the fourth resistor is connected in series to the third switch.

5. The TIA according to claim 3 or 4, wherein the third feedback branch further comprises a feedback capacitor, the feedback capacitor is connected in parallel to two ends of the fourth resistor, and the feedback capacitor is configured to compensate for a phase margin.

6. The TIA according to claim 4 or 5, wherein two ends of the feedback resistor circuit are further connected in parallel to a second voltage clamping circuit; the second voltage clamping circuit comprises a third PMOS transistor and a third NMOS transistor that have a common gate, gates of the third PMOS transistor and the third NMOS transistor are connected to an input end of the feedback resistor circuit, a source of the third NMOS transistor and a drain of the third PMOS transistor are connected to an output end of the feedback resistor circuit, a drain of the third NMOS transistor is connected to the direct current power supply, and a source of the third PMOS transistor is grounded.

7. The TIA according to any one of claims 1 to 6, wherein the TIA further comprises a load circuit, wherein an input end of the load circuit is connected to the output end of the inverting amplification circuit, an output end of the load circuit is the output end of the trans-impedance amplifier TIA, and the load circuit is configured to adjust a gain of the inverting amplification circuit.

8. The TIA according to claim 7, wherein the load circuit comprises a load PMOS transistor and a load NMOS transistor, wherein
a gate of the load PMOS transistor is connected to a gate of the load NMOS transistor to form the input end of the load circuit, a source of the load PMOS transistor is connected to a drain of the load NMOS transistor, and the gate of the load PMOS transistor and the gate of the load NMOS transistor are connected to the source of the load PMOS transistor and the drain of the load NMOS transistor.

9. The TIA according to claim 8, wherein the load circuit further comprises a load capacitor, a first end of the load capacitor is connected to the output end of the load circuit, a second end of the load capacitor is grounded, and the load capacitor is configured to adjust an open-loop bandwidth of the inverting amplification circuit.

10. A trans-impedance amplifier TIA, wherein the TIA comprises a first inverting amplifier, a second inverting amplifier, a third inverting amplifier, a first voltage clamping circuit, a second voltage clamping circuit, and a third voltage clamping circuit, wherein
the first inverting amplifier, the second inverting amplifier, and the third inverting amplifier are sequentially connected in series, the first voltage clamping circuit is connected in parallel to two ends of the first inverting amplifier, the second voltage clamping circuit is connected in parallel to two ends of the second inverting amplifier, and the third voltage clamping circuit is connected in parallel to two ends of the third inverting amplifier;
the first inverting amplifier comprises a first PMOS transistor and a first NMOS transistor that have a common gate, gates of the first PMOS transistor and the first NMOS transistor are connected to form an input end of the TIA, and a source of the first PMOS transistor is connected to a drain of the first NMOS transistor to form an output end of the first inverting amplifier;
the second inverting amplifier comprises a second PMOS transistor and a second NMOS transistor that have a common gate, gates of the second PMOS transistor and the second NMOS transistor are connected to form an input end of the second inverting amplifier, the input end of the second inverting amplifier is connected to the output end of the first inverting amplifier, and a source of the second PMOS transistor is connected to a drain of the second NMOS transistor to form an output end of the second inverting amplifier;
the third inverting amplifier comprises a third PMOS transistor and a third NMOS transistor that have a common gate, gates of the third PMOS transistor and the third NMOS transistor are connected to form an input end of the third inverting amplifier, the input end of the third inverting amplifier is connected to the output end of the second inverting amplifier, and a source of the third PMOS transistor is connected to a drain of the third NMOS transistor to form an output end of the TIA;
the first voltage clamping circuit comprises a fourth PMOS transistor and a fourth NMOS transistor that have a common gate, gates of the fourth PMOS transistor and the fourth NMOS transistor are connected to the input end of the TIA, a source of the fourth NMOS transistor and a drain of the fourth PMOS transistor are connected to the output end of the first inverting amplifier, a drain of the fourth NMOS transistor is connected to a direct current power supply, and a source of the fourth PMOS transistor is grounded;
the second voltage clamping circuit comprises a fifth PMOS transistor and a fifth NMOS transistor that have a common gate, gates of the fifth PMOS transistor and the fifth NMOS transistor are connected to the input end of the second inverting amplifier, a source of the fifth NMOS transistor and a drain of the fifth PMOS transistor are connected to the output end of the second inverting amplifier, a drain of the fifth NMOS transistor is connected to the direct current power supply, and a source of the fifth PMOS transistor is grounded; and
the third voltage clamping circuit comprises a sixth PMOS transistor and a sixth NMOS transistor that have a common gate, gates of the sixth PMOS transistor and the sixth NMOS transistor are connected to the input end of the third inverting amplifier, a source of the sixth NMOS transistor and a drain of the sixth PMOS transistor are connected to the output end of the TIA, a drain of the sixth NMOS transistor is connected to the direct current power supply, and a source of the sixth PMOS transistor is grounded.

11. The TIA according to claim 10, wherein turn-on voltages of the fourth PMOS transistor and the fourth NMOS transistor are both less than turn-on voltages of the first PMOS transistor and the first NMOS transistor;
turn-on voltages of the fifth PMOS transistor and the fifth NMOS transistor are both less than turn-on voltages of the second PMOS transistor and the second NMOS transistor; and
turn-on voltages of the sixth PMOS transistor and the sixth NMOS transistor are both less than turn-on voltages of the third PMOS transistor and the third NMOS transistor.

12. The TIA according to claim 10 or 11, wherein the TIA further comprises a feedback resistor circuit, a first end of the feedback resistor circuit is connected to the output end of the TIA, a second end of the feedback resistor circuit is connected to the input end of the TIA, and the feedback resistor circuit is configured to convert an input current signal of the TIA into a voltage signal.

13. The TIA according to claim 12, wherein the feedback resistor circuit comprises a first feedback branch, a second feedback branch, and a third feedback branch that are connected in parallel;
the first feedback branch comprises a first resistor, a second resistor, and a first switch, the first resistor is connected in series to the second resistor, and the first switch is connected in parallel to two ends of the second resistor;
the second feedback branch comprises a third resistor and a second switch, and the third resistor is connected in series to the second switch; and
the third feedback branch comprises a fourth resistor and a third switch, and the fourth resistor is connected in series to the third switch.

14. The TIA according to claim 12 or 13, wherein the third feedback branch further comprises a feedback capacitor, the feedback capacitor is connected in parallel to two ends of the fourth resistor, and the feedback capacitor is configured to compensate for a phase margin.

15. The TIA according to claim 13 or 14, wherein two ends of the feedback resistor circuit are further connected in parallel to a fourth voltage clamping circuit, wherein
the fourth voltage clamping circuit comprises a third PMOS transistor and a third NMOS transistor that have a common gate, gates of the third PMOS transistor and the third NMOS transistor are connected to an input end of the feedback resistor circuit, a source of the third NMOS transistor and a drain of the third PMOS transistor are connected to an output end of the feedback resistor circuit, a drain of the third NMOS transistor is connected to the direct current power supply, and a source of the third PMOS transistor is grounded.

16. The TIA according to any one of claims 10 to 15, wherein the TIA further comprises a first load circuit, a second load circuit, and a third load circuit, wherein
the first load circuit comprises a first load PMOS transistor, a first load NMOS transistor, a fourth switch, and a fifth switch, a gate of the first load PMOS transistor is connected to a gate of the first load NMOS transistor, a source of the first load PMOS transistor is connected to a drain of the first load NMOS transistor, and the gate of the first load PMOS transistor and the gate of the first load NMOS transistor are connected to the source of the first load PMOS transistor and the drain of the first load NMOS transistor;
the gate of the first load PMOS transistor and the gate of the first load NMOS transistor are connected to the output end of the first inverting amplifier, and the source of the first load PMOS transistor and the drain of the first load NMOS transistor are connected to the input end of the second inverting amplifier; one end of the fourth switch is connected to the direct current power supply, and the other end is connected to a drain of the first load PMOS transistor; and one end of the fifth switch is connected to a source of the first load NMOS transistor, and the other end is grounded;
the second load circuit comprises a second load PMOS transistor, a second load NMOS transistor, a third load PMOS transistor, a third load NMOS transistor, a sixth switch, and a seventh switch, a gate of the second load PMOS transistor is connected to a gate of the second load NMOS transistor, a source of the second load PMOS transistor is connected to a drain of the second load NMOS transistor, and the gate of the second load PMOS transistor and the gate of the second load NMOS transistor are connected to the source of the second load PMOS transistor and the drain of the second load NMOS transistor;
a gate of the third load PMOS transistor is connected to a gate of the third load NMOS transistor, a source of the third load PMOS transistor is connected to a drain of the third load NMOS transistor, and the gate of the third load PMOS transistor and the gate of the third load NMOS transistor are connected to the source of the third load PMOS transistor and the drain of the third load NMOS transistor;
the gate of the second load PMOS transistor and the gate of the second load NMOS transistor are connected to the output end of the second inverting amplifier, and the source of the second load PMOS transistor and the drain of the second load NMOS transistor are connected to the gate of the third load PMOS transistor and the gate of the third load NMOS transistor; one end of the sixth switch is connected to the direct current power supply, and the other end is connected to a drain of the second load PMOS transistor; and one end of the seventh switch is connected to a source of the second load NMOS transistor, and the other end is grounded;
the source of the third load PMOS transistor and the drain of the third load NMOS transistor are connected to the input end of the third inverting amplifier; and
the third load circuit comprises a fourth load PMOS transistor and a fourth load NMOS transistor, a gate of the fourth load PMOS transistor is connected to a gate of the fourth load NMOS transistor, a source of the fourth load PMOS transistor is connected to a drain of the fourth load NMOS transistor, the gate of the fourth load PMOS transistor and the gate of the fourth load NMOS transistor are connected to an output end of the third inverting amplifier, and the source of the fourth load PMOS transistor and the drain of the fourth load NMOS transistor are the output end of the TIA.

17. The TIA according to claim 16, wherein the first load circuit further comprises a first load capacitor and an eighth switch, and the second load circuit further comprises a second feedback capacitor and a ninth switch, wherein
one end of the eighth switch is connected to the source of the first load PMOS transistor and the drain of the first load NMOS transistor, the other end is connected to one end of the first load capacitor, and the other end of the first load capacitor is grounded; and
one end of the ninth switch is connected to the source of the third load PMOS transistor and the drain of the third load NMOS transistor, the other end is connected to one end of the second load capacitor, and the other end of the second load capacitor is grounded.

18. A trans-impedance amplifier TIA control method, wherein the control method comprises:
when a conversion rate corresponding to the TIA is a first conversion rate, controlling a first switch in a feedback resistor circuit to be on; and
when the conversion rate corresponding to the TIA is a second conversion rate, controlling the first switch in the feedback resistor circuit to be off, wherein
the TIA comprises a first inverting amplifier, a second inverting amplifier, a third inverting amplifier, a first voltage clamping circuit, a second voltage clamping circuit, and a third voltage clamping circuit;
the first inverting amplifier, the second inverting amplifier, and the third inverting amplifier are sequentially connected in series, the first voltage clamping circuit is connected in parallel to two ends of the first inverting amplifier, the second voltage clamping circuit is connected in parallel to two ends of the second inverting amplifier, and the third voltage clamping circuit is connected in parallel to two ends of the third inverting amplifier;
the first inverting amplifier comprises a first PMOS transistor and a first NMOS transistor that have a common gate, gates of the first PMOS transistor and the first NMOS transistor are connected to form an input end of the TIA, and a source of the first PMOS transistor is connected to a drain of the first NMOS transistor to form an output end of the first inverting amplifier;
the second inverting amplifier comprises a second PMOS transistor and a second NMOS transistor that have a common gate, gates of the second PMOS transistor and the second NMOS transistor are connected to form an input end of the second inverting amplifier, the input end of the second inverting amplifier is connected to the output end of the first inverting amplifier, and a source of the second PMOS transistor is connected to a drain of the second NMOS transistor to form an output end of the second inverting amplifier;
the third inverting amplifier comprises a third PMOS transistor and a third NMOS transistor that have a common gate, gates of the third PMOS transistor and the third NMOS transistor are connected to form an input end of the third inverting amplifier, the input end of the third inverting amplifier is connected to the output end of the second inverting amplifier, and a source of the third PMOS transistor is connected to a drain of the third NMOS transistor to form an output end of the TIA;
the first voltage clamping circuit comprises a fourth PMOS transistor and a fourth NMOS transistor that have a common gate, gates of the fourth PMOS transistor and the fourth NMOS transistor are connected to the input end of the TIA, a source of the fourth NMOS transistor and a drain of the fourth PMOS transistor are connected to the output end of the first inverting amplifier, a drain of the fourth NMOS transistor is connected to a direct current power supply, and a source of the fourth PMOS transistor is grounded;
the second voltage clamping circuit comprises a fifth PMOS transistor and a fifth NMOS transistor that have a common gate, gates of the fifth PMOS transistor and the fifth NMOS transistor are connected to the input end of the second inverting amplifier, a source of the fifth NMOS transistor and a drain of the fifth PMOS transistor are connected to the output end of the second inverting amplifier, a drain of the fifth NMOS transistor is connected to the direct current power supply, and a source of the fifth PMOS transistor is grounded;
the third voltage clamping circuit comprises a sixth PMOS transistor and a sixth NMOS transistor that have a common gate, gates of the sixth PMOS transistor and the sixth NMOS transistor are connected to the input end of the third inverting amplifier, a source of the sixth NMOS transistor and a drain of the sixth PMOS transistor are connected to the output end of the TIA, a drain of the sixth NMOS transistor is connected to the direct current power supply, and a source of the sixth PMOS transistor is grounded;
the TIA further comprises a feedback resistor circuit, a first end of the feedback resistor circuit is connected to the output end of the TIA, a second end of the feedback resistor circuit is connected to the input end of the TIA, and the feedback resistor circuit is configured to convert an input current signal of the TIA into a voltage signal;
the feedback resistor circuit comprises a first feedback branch, a second feedback branch, and a third feedback branch that are connected in parallel;
the first feedback branch comprises a first resistor, a second resistor, and the first switch, the first resistor is connected in series to the second resistor, and the first switch is connected in parallel to two ends of the second resistor;
the second feedback branch comprises a third resistor and a second switch, and the third resistor is connected in series to the second switch; and
the third feedback branch comprises a fourth resistor and a third switch, and the fourth resistor is connected in series to the third switch.

19. The control method according to claim 18, wherein the TIA further comprises a first load circuit, a second load circuit, and a third load circuit, wherein
the first load circuit comprises a first load PMOS transistor, a first load NMOS transistor, a first load switch, and a second load switch, a gate of the first load PMOS transistor is connected to a gate of the first load NMOS transistor, a source of the first load PMOS transistor is connected to a drain of the first load NMOS transistor, and the gate of the first load PMOS transistor and the gate of the first load NMOS transistor are connected to the source of the first load PMOS transistor and the drain of the first load NMOS transistor;
the gate of the first load PMOS transistor and the gate of the first load NMOS transistor are connected to the output end of the first inverting amplifier, and the source of the first load PMOS transistor and the drain of the first load NMOS transistor are connected to the input end of the second inverting amplifier; one end of the first load switch is connected to the direct current power supply, and the other end is connected to a drain of the first load PMOS transistor; and one end of the second load switch is connected to a source of the first load NMOS transistor, and the other end is grounded;
the second load circuit comprises a second load PMOS transistor, a second load NMOS transistor, a third load PMOS transistor, a third load NMOS transistor, a third load switch, and a fourth load switch, a gate of the second load PMOS transistor is connected to a gate of the second load NMOS transistor, a source of the second load PMOS transistor is connected to a drain of the second load NMOS transistor, and the gate of the second load PMOS transistor and the gate of the second load NMOS transistor are connected to the source of the second load PMOS transistor and the drain of the second load NMOS transistor;
a gate of the third load PMOS transistor is connected to a gate of the third load NMOS transistor, a source of the third load PMOS transistor is connected to a drain of the third load NMOS transistor, and the gate of the third load PMOS transistor and the gate of the third load NMOS transistor are connected to the source of the third load PMOS transistor and the drain of the third load NMOS transistor;
the gate of the second load PMOS transistor and the gate of the second load NMOS transistor are connected to the output end of the second inverting amplifier, and the source of the second load PMOS transistor and the drain of the second load NMOS transistor are connected to the gate of the third load PMOS transistor and the gate of the third load NMOS transistor; one end of the third load switch is connected to the direct current power supply, and the other end is connected to a drain of the second load PMOS transistor; and one end of the fourth load switch is connected to a source of the second load NMOS transistor, and the other end is grounded;
the source of the third load PMOS transistor and the drain of the third load NMOS transistor are connected to the input end of the third inverting amplifier; and
the third load circuit comprises a fourth load PMOS transistor and a fourth load NMOS transistor, a gate of the fourth load PMOS transistor is connected to a gate of the fourth load NMOS transistor, a source of the fourth load PMOS transistor is connected to a drain of the fourth load NMOS transistor, the gate of the fourth load PMOS transistor and the gate of the fourth load NMOS transistor are connected to an output end of the third inverting amplifier, and the source of the fourth load PMOS transistor and the drain of the fourth load NMOS transistor are the output end of the TIA;
when the TIA corresponds to a high gain mode, the second switch and the third switch are controlled to be off, and the first load switch, the second load switch, the third load switch, and the fourth load switch are controlled to be off;
when the TIA corresponds to a medium gain mode, the second switch is controlled to be on and the third switch is controlled to be off, and the first load switch and the second load switch are controlled to be off and the third load switch and the fourth load switch are controlled to be on; and
when the TIA corresponds to a low gain mode, the second switch and the third switch are controlled to be on, and the first load switch, the second load switch, the third load switch, and the fourth load switch are controlled to be on.

20. A photoelectric converter, wherein the photoelectric converter comprises a photoelectric detector, and the trans-impedance amplifier TIA according to any one of claims 1 to 9 or the TIA according to any one of claims 10 to 17, wherein
an output end of the photoelectric detector is connected to an input end of the TIA;
the photoelectric detector is configured to receive an optical signal, and convert the optical signal into a current signal; and
the TIA is configured to amplify the current signal, and convert the current signal into a voltage signal.
